(19) Europäisches Patentamt
European Patent Office
Office européen des brevets

(11) Veröffentlichungsnummer: 0 343 470 A2

# (12) EUROPÄISCHE PATENTANMELDUNG

(21) Anmeldenummer: 89108675.3

(22) Anmeldetag: 13.05.89

(51) Int. Cl.[4]: G03C 1/68

(30) Priorität: 21.05.88 DE 3817424

(43) Veröffentlichungstag der Anmeldung: 29.11.89 Patentblatt 89/48

(84) Benannte Vertragsstaaten: AT CH DE FR GB IT LI NL

(71) Anmelder: HOECHST AKTIENGESELLSCHAFT
Postfach 80 03 20
D-6230 Frankfurt am Main 80(DE)

(72) Erfinder: Gersdorf, Joachim, Dr.
Lohmühlweg 17
D-6200 Wiesbaden(DE)
Erfinder: Kleiner, Hans-Jerg, Dr.
Altkönigstrasse 11a
D-6242 Kronberg(DE)

## (54) Alkenylphosphon- und -phosphinsäureester, Verfahren zu ihrer Herstellung und durch Strahlung polymerisierbares Gemisch, das diese Verbindungen enthält.

(57) Es werden Ester von drei- oder vierwertigen Alkoholen mit Alkenylphosphon- oder -phosphinsäuren beschrieben, die radikalisch polymerisierbar sind. Sie werden zusammen mit polymeren Bindemitteln, insbesondere wasserlöslichen Polymeren und radikalbildenden Photoinitiatoren zu photopolymerisierbaren Gemischen kombiniert, die zur Herstellung von Photoresists und Druckplatten geeignet sind. Die Gemische sind wenig temperaturempfindlich und gut lagerfähig.

EP 0 343 470 A2

Xerox Copy Centre

## Alkenylphosphon- und -phosphinsäureester, Verfahren zu ihrer Herstellung und durch Strahlung polymerisierbares Gemisch, das diese Verbindungen enthält

Diese Erfindung betrifft Alkenylphosphon- und -phosphinsäureester von bestimmten mehrwertigen Alkanolen, Verfahren zu ihrer Herstellung sowie durch Strahlung polymerisierbare Gemische, die diese Ester als polymerisierbare Verbindungen enthalten.

Ester und andere Derivate von Alkenylphosphon- und -phosphinsäuren mit zumeist einwertigen Alkoholen sind bekannt und werden zur Herstellung von Polymeren, z. B. von Polyvinylphosphonsäure und ihren Derivaten, großtechnisch eingesetzt. Eine unmittelbare Verwertung der genannten ungesättigten Verbindungen - außer zur Herstellung von Polymeren - ist bisher nur in geringfügigem Umfang erfolgt, wobei man praktisch nur die Säureeigenschaften der Monomeren nutzte, ohne von der Polymerisationsfähigkeit der Alkenylgruppe Gebrauch zu machen. Das ist vermutlich auf die relativ geringe Polymerisationsneigung der bekannten Alkenylphosphonsäuren oder ihrer Derivate zurückzuführen, die in der DE-C 1 106 963 erwähnt wird.

Photopolymerisierbare Gemische zur Herstellung von Druckplatten, Photoresists und anderen lichtempfindlichen Materialien enthalten radikalisch polymerisierbare Verbindungen, die bei Belichtung in Gegenwart eines Photoinitiators zu vernetzten, unlöslichen Produkten polymerisieren. Als solche Verbindungen sind bisher praktisch ausschließlich Ester ungesättigter Carbonsäuren, insbesondere der Acryl- und Methacrylsäure, mit mehrwertigen aliphatischen oder cycloaliphatischen Alkoholen, die ggf. Urethan- oder Ethergruppen enthalten können, eingesetzt worden. Es werden in älteren Druckschriften, z. B. in der US-A 2 892 716, auch Divinylester von aromatischen oder aliphatischen Disulfonsäuren als polymerisierbare Verbindungen erwähnt, doch haben diese keinen Eingang in die Praxis gefunden.

Die bisher bevorzugten (Meth)acrylate mehrwertiger Alkohole haben, zumindest für einige Anwendungszwecke, bestimmte Nachteile. Sie sind bei höheren Temperaturen, z. B. oberhalb 150° C, instabil; außerdem weisen viele niedermolekulare Vertreter eine hohe Flüchtigkeit auf, die sich bei längerer Lagerung in der Schicht und bei der Verarbeitung bei höheren Temperaturen bemerkbar macht. Außerdem sind die meisten bevorzugten Vertreter wasserunlöslich und dadurch schwerer mit wasserlöslichen oder hydrophilen Bindemitteln kombinierbar. Auch verursachen die meisten (Meth)acrylate störende Hautreizungen.

Aufgabe der Erfindung war es, neue polymerisierbare Verbindungen bereitzustellen, deren Polymerisationsfähigkeit unter Bestrahlung in Gegenwart von strahlungsaktivierbaren Polymerisationsinitiatoren, insbesondere Photoinitiatoren, ähnlich gut wie die der bisher technisch genutzten Acryl- bzw. Methacrylsäureester ist und die wasserlöslich, weniger flüchtig und weniger hautreizend sind.

Erfindungsgemäß werden neue Verbindungen der allgemeinen Formel I

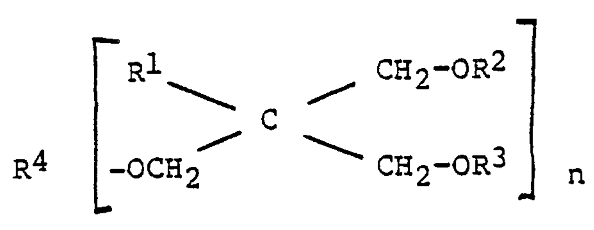

(I)

vorgeschlagen, worin

$R^1$ eine Alkylgruppe mit 1 bis 4 Kohlenstoffatomen, $CH_2OH$ oder $CH_2OR^7$,

$R^2$ eine Gruppe der Formel II

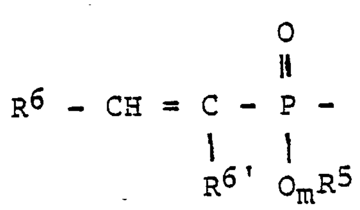

(II) und

$R^3$ ein Wasserstoffatom oder eine Gruppe der Formel II ist

oder worin
$R^2$ und $R^3$ zusammen eine Gruppe der Formel III

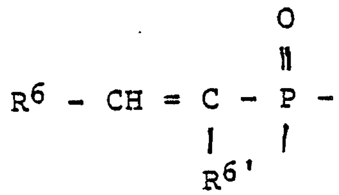

(III)

bedeuten,
n 1 oder 2,
$R^4$ bei n = 1 ein Wasserstoffatom, eine Gruppe der Formel II oder, wenn $R^2$ und $R^3$ eine Gruppe der Formel III bilden und $R^1$ eine Alkylgruppe ist, auch eine Gruppe der Formel IV

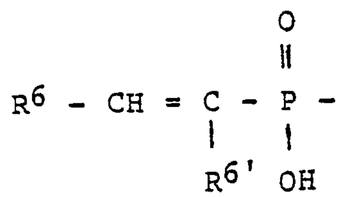

(IV)

und bei n = 2 eine Gruppe der Formel III bedeutet,
$R^5$ eine Alkylgruppe mit 1 bis 4 Kohlenstoffatomen,
$R^6$ und $R^{6'}$ gleich oder verschieden sind und Wasserstoffatome oder Alkylgruppen mit 1 bis 4 Kohlenstoffatomen sind und
$R^7$ eine Gruppe der Formel II ist,
oder worin, bei n = 1, $R^4$ und $R^7$ zusammen eine Gruppe der Formel III bedeuten und
m O oder 1 ist.

Erfindungsgemäß wird ferner ein Verfahren zur Herstellung der Verbindungen der Formel I vorgeschlagen, das darin besteht, daß man eine Alkenylphosphonsäureverbindung der Formel V

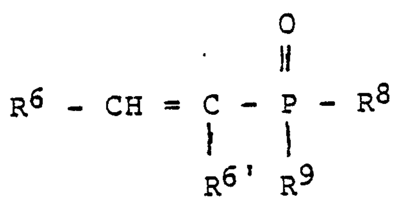

(V)

oder eine Alkenylphosphinsäureverbindung der Formel VI

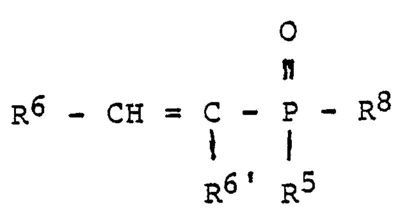

(VI)

,

worin
$R^8$ und $R^9$ gleich oder verschieden sind und Halogenatome, OH-Gruppen oder Alkoxygruppen mit 1 bis 4 Kohlenstoffatomen
bedeuten und $R^5$, $R^6$ und $R^{6'}$ die oben angegebene Bedeutung haben, mit einem drei- oder vierwertigen Alkohol der Formel VII

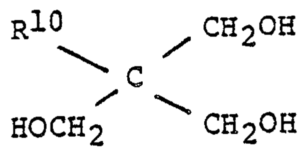 , (VII)

worin

$R^{10}$ eine Alkylgruppe mit 1 bis 4 Kohlenstoffatomen oder eine $CH_2OH$-Gruppe ist,

zu einer Verbindung der Formel I umsetzt.

Gemäß einer Ausführungsform des Verfahrens wird ein Alkenylphosphonsäurehalogenid der Formel V mit $R^8$ = $R^9$ = Halogen, vorzugsweise Chlor, in Gegenwart eines tertiären Amins im Molverhältnis 1:2:1 in einem geeigneten inerten Lösungsmittel mit einem 1,1,1-Tris-hydroxymethyl-alkan umgesetzt. Als tertiäres Amin kann z. B. Triethylamin, N,N′-Dimethylanilin oder Pyridin eingesetzt werden. Als Lösungsmittel eignen sich z. B. Methylenchlorid, Toluol, Acetonitril oder Tetrahydrofuran. Die Umsetzungen verlaufen vorzugsweise unter Kühlung bei -10 bis +40° C. Überraschenderweise erhält man dabei z. B. die Verbindungen 1 und 2 der Tabelle I in sehr guten Ausbeuten.

Gemäß einer anderen Ausführungsform wird ein Alkenylphosphinsäurehalogenid der Formel VI mit $R^8$ = Halogen, z. B. das Methyl-vinylphosphinsäurechlorid, in Gegenwart eines tertiären Amins mit einem 1,1,1-Trishydroxymethyl-alkan oder dem Pentaerythrit zu einer Verbindung der Formel I mit $R^1$ = Alkyl oder $CH_2OR^7$ umgesetzt. Auf diese Weise wird die Verbindung 7 erhalten.

Gemäß einer weiteren Variante können nach diesem Verfahren auch Alkenylphosphonsäureesterhalogenide eingesetzt werden, z. B. erhält man die Verbindung 8 aus 3 mol Vinylphosphonsäureethylesterchlorid, 3 mol tertiärem Amin und 1 mol 1,1,1-Trimethylolpropan.

Anfallende Produkte, die noch freie Hydroxylgruppen enthalten, können weiter umgesetzt werden, z. B. mit Alkenylphosphonsäureanhydriden, wie Vinylphosphonsäureanhydrid. Dabei wird in einem inerten Lösungsmittel, z. B. Methylenchlorid oder Dimethylformamid, gearbeitet. Man erhält auf diesem Weg die Verbindung 3 aus 1 Grundmol Vinylphosphonsäureanhydrid und 1 mol Verbindung 2.

Es ist weiterhin möglich, erfindungsgemäße Verbindungen mit freien OH-Gruppen, z.B. die Verbindungen 1, 2 oder 6, mit Alkenylphosphinsäurechloriden oder Alkenyl phosphonsäureesterchloriden umzusetzen. Dabei werden dann z. B. die Verbindungen 4 und 5 erhalten.

Auch können Alkenylphosphonsäuredichloride z. B. mit den Verbindungen 1, 2 oder 6 umgesetzt werden. Dabei wird z. B. aus Verbindung 2 die Verbindung 9 erhalten.

Gemäß einer anderen Ausführungsform des Verfahrens werden Alkenylphosphonsäuren bzw. Alkenylphosphinsäuren mit mehrwertigen Alkoholen der Formel VII verestert. Dabei werden die Säuren und der entsprechende Alkohol im jeweils gewünschten stöchiometrischen Verhältnis gemischt und dann im geeigneten Vakuum bei 150 bis 250° C, vorzugsweise 160 bis 220° C, gehalten. Dabei erfolgt dann unter Wasseraustritt Veresterung. Es kann zweckmäßig sein, bestimmte bekannte Polymerisationsinhibitoren zuzusetzen, z. B. Hydrochinon, Hydrochinonmonomethylether oder Phenothiazin. Es kann weiterhin vorteilhaft sein, die Veresterung nicht bis zur Vollständigkeit durchzuführen, sondern bei einem bestimmten Restsäuregehalt abzubrechen, da sonst die Reaktionsdauer zu lange ausgedehnt werden muß und unter diesen Bedingungen eine Polymerisation des Reaktionsgutes nicht immer zu verhindern ist. Beispielsweise erhält man die Verbindungen 2 und 7 durch Verestern von Vinylphosphonsäure bzw. Vinylmethylphosphinsäure mit 1,1,1-Trimethylolpropan.

Schließlich können auch Alkenylphosphon- und -phosphinsäureester mit Alkoholen der Formel VII in Gegenwart geeigneter Katalysatoren umgeestert werden. Als Katalysatoren können z. B. Alkalialkoholate oder Alkalihydride, z. B. Natriumhydrid, aber auch Orthotitansäure-tetraisopropylester eingesetzt werden. Die Umesterungsreaktion wird bevorzugt im Vakuum im Temperaturbereich 150 bis 250° C, insbesondere 180 bis 220° C, durchgeführt. Beispielsweise erhält man hiernach aus 3 mol Vinyl-methylphosphinsäureethylester und 1 mol Trimethylolpropan die Verbindung 7.

Die bei den angegebenen Verfahren anfallenden Alkenylphosphon- und -phosphinsäureester können durch Destillation im Hochvakuum, insbesondere mit Hilfe eines Dünnschichtverdampfers, gereinigt werden. Teilweise können sie auch direkt als Rohprodukt ohne weitere Reinigung eingesetzt werden.

In der allgemeinen Formel I hat $R^1$, wenn es ein Alkylrest ist, vorzugsweise 1 oder 2 Kohlenstoffatome. $R^5$ hat bevorzugt 1 bis 3 Kohlenstoffatome, $R^6$ ist bevorzugt eine Methylgruppe oder ein Wasserstoffatom, insbesondere ein Wasserstoffatom.

Die erfindungsgemäßen Verbindungen finden Verwendung als polymerisierbare Verbindungen in durch Strahlung, insbesondere durch sichtbares oder ultraviolettes Licht, polymerisierbaren Gemischen. Erfindungsgemäß wird daher auch ein durch Strahlung polymerisierbares Gemisch vorgeschlagen, das als wesentliche Bestandteile

a) ein polymeres Bindemittel,

b) eine radikalisch polymerisierbare Verbindung und

c) eine Verbindung oder eine Verbindungskombination, die unter Einwirkung aktinischer Strahlung die Polymerisation der Verbindung (b) zu initiieren vermag,

enthält.

Das erfindungsgemäße Gemisch ist dadurch gekennzeichnet, daß die polymerisierbare Verbindung eine Verbindung der vorstehend angegebenen allgemeinen Formel I ist.

Erfindungsgemäß wird weiterhin ein durch Strahlung polymerisierbares Aufzeichnungsmaterial mit einer strahlungsempfindlichen Schicht und ggf. einem Schichtträger vorgeschlagen, bei dem die Schicht aus einem Gemisch der vorstehend genannten Zusammensetzung besteht.

Ein wesentlicher Vorteil der erfindungsgemäßen Verbindungen ist deren sehr gute Löslichkeit sowohl in polaren als auch in unpolaren Lösungsmitteln. So sind die erfindungsgemäßen Verbindungen im Gegensatz zu Trimethylolpropantriacrylat bzw. Trimethylolpropantrimethacrylat in jedem Verhältnis mit Wasser mischbar. Bei den erfindungsgemäßen Verbindungen handelt es sich um schwerflüchtige, geruchsarme Substanzen. Daraus resultiert als weiterer Vorteil die wesentlich geringere Neigung zur Diffusion oder Verdunstung aus photopolymerisierbaren Schichten. Sie zeichnen sich ferner durch eine deutlich höhere Thermostabilität als die gebräuchlichen Acryl- und Methacrylsäureester aus.

Der Mengenanteil der Schicht an Monomeren beträgt im allgemeinen etwa 5 bis 80, vorzugsweise 8 bis 60 Gew.-%.

Als Bindemittel können eine Vielzahl löslicher organischer Polymerer Einsatz finden. Als Beispiele seien genannt: Polyamide, Polyvinylester, Polyvinylacetale, Epoxidharze, Polyacrylsäureester, Polymethacrylsäureester, Polyester, Alkydharze, Polybutadien, Polyisopren, Isopren-Styrol-Blockcopolymere und andere Elastomere, sowie Mischpolymerisate der Monomeren, die die aufgezählten Homopolymerisate bilden.

Es können auch Bindemittel verwendet werden, die wasserunlöslich, aber in wäßrig-alkalischen Lösungen löslich oder mindestens quellbar sind, da sich Schichten mit solchen Bindemitteln mit wäßrig-alkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren, Vinylacetat/Crotonsäure-, Styrol/Maleinsäureanhydrid-, Alkyl methacrylat/Methacrylsäure-Mischpolymerisate und Mischpolymerisate aus Methacrylsäure, höheren Alkylmethacrylaten und Methylmethacrylat und/oder Styrol oder Acrylnitril.

Mit besonderem Vorteil werden Gemische auf Basis wasserlöslicher Bindemittel eingesetzt, da sich die erfindungsgemäßen wasserlöslichen polymerisierbaren Verbindungen mit diesen besonders leicht kombinieren lassen und eine bequeme und umweltfreundliche Beschichtung aus wäßriger Lösung erlauben. Beispiele für solche Bindemitel sind Polyvinylalkohol, teilverseifte Polyvinylacetate und Vinylacetat-Mischpolymerisate, Polyvinylether, Polyvinylpyrrolidon, Polyacrylamid, Polydimethylacrylamid, Polyethylenoxid, Polyvinylmethylformamid, Polyvinylmethylacetamid sowie wasserlösliche natürliche Polymere.

Die Menge des Bindemittels beträgt im allgemeinen 20 bis 95, vorzugsweise 40 bis 90 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind: Polymerisationsinhibitoren, Wasserstoffdonatoren, Farbstoffe, gefärbte und ungefärbte Pigmente und Weichmacher.

Als aktinische Strahlung soll im Rahmen dieser Beschreibung jede Strahlung verstanden werden, deren Energie mindestens der des sichtbaren Lichts entspricht. Geeignet ist u. a. sichtbares Licht, langwellige und kurzwellige UV-Strahlung, Laserstrahlung, Elektronen- und Röntgenstrahlung.

Als Photoinitiatoren in dem erfindungsgemäßen Gemisch können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinoxaline ableiten; ferner Trichlormethyl-s-triazine, 2-Halogenmethyl-5-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450 oder Acylphosphinoxidverbindungen, wie sie z. B. in der DE-A 31 33 419 beschrieben sind.

Die Initiatoren werden allgemein in einer Menge von 0,01 bis 10, vorzugsweise von 0,05 bis 4 Gew.-%, bezogen auf die nichtflüchtigen Bestandteile des Gemischs, eingesetzt.

Wenn die Bebilderung mit Röntgen- oder Elektronenstrahlen durchgeführt wird, sind neben den

bekannten für sichtbares und nahes UV-Licht empfindlichen Photoinitiatoren auch solche geeignet, deren Absorptionsbereiche im kurzwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß man die Materialien besser lagerfähig machen kann. Als Beispiele für derartige Starter sind Tribrommethyl-phenylsulfon, 2,2′,4,4′,6,6′-Hexabromdiphenylamin, Pentabromethan, 2,3,4,5-Tetrachloranilin, Pentaerythrittetrabromid, Chlorterphenylharze oder chlorierte Paraffine zu nennen.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, besonders Flexodruck, den Flachdruck, den Tiefdruck, den Siebdruck, von Reliefkopien, z. B. Herstellung von Texten in Blin denschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Druckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen, der mechanisch abziehbar oder entwicklerlöslich sein kann.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf einen Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerflüssigkeit, z. B. mit organischen Lösemitteln, mit schwach alkalischen wäßrigen Lösungen oder vorteilhaft mit Wasser allein, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Darin sind Prozent- und Mengenverhältnisse, wenn nichts anderes angegeben ist, in Gewichtseinheiten zu verstehen. Es wird zunächst in einer Anzahl von Herstellungsbeispielen die Synthese von einigen erfindungsgemäßen Verbindungen beschrieben. Diese und andere erfindungsgemäß hergestellte Verbindungen sind in der folgenden Tabelle I angegeben. Auf die Herstellungsbeispiele folgen einige Anwendungsbeispiele, die den Einsatz der polymerisierbaren Verbindungen in photopolymerisierbaren Aufzeichnungsmaterialien beschreiben.

Tabelle I (Verbindungen der Formel I)

| Verbindung Nr. | $R^1$ | $R^4$ | $R^2$ | $R^3$ | n |
|---|---|---|---|---|---|
| 1 | $CH_3$ | H | $>\underset{O}{\underset{\|}{P}} - CH = CH_2$ | | 1 |
| 2 | $C_2H_5$ | " | " | | " |
| 3 | " | $HO-\underset{O}{\underset{\|}{P}}-CH=CH_2$ | " | | " |
| 4 | " | $CH_3-\underset{O}{\underset{\|}{P}}-CH=CH_2$ | " | | " |
| 5 | " | $C_2H_5O-\underset{O}{\underset{\|}{P}}-CH=CH_2$ | " | | " |
| 6 | " | H | $CH_3-\underset{O}{\underset{\|}{P}}-CH=CH_2$ | $CH_3-\underset{O}{\underset{\|}{P}}-CH=CH_2$ | " |
| 7 | " | $CH_3-\underset{O}{\underset{\|}{P}}-CH=CH_2$ | " | " | " |
| 8 | " | $C_2H_5O-\underset{O}{\underset{\|}{P}}-CH=CH_2$ | $C_2H_5O-\underset{O}{\underset{\|}{P}}-CH=CH_2$ | $C_2H_5O-\underset{O}{\underset{\|}{P}}-CH=CH_2$ | " |
| 9 | " | $>\underset{O}{\underset{\|}{P}} - CH = CH_2$ | $>\underset{O}{\underset{\|}{P}} - CH = CH_2$ | | 2 |
| 10 | $>\underset{O}{\underset{\|}{P}} - CH = CH_2$ | | " | | 1 |
| 11 | $-CH_2O-R^7$ | $R^2 = R^3 = R^4 = R^7 = CH_3-\underset{O}{\underset{\|}{P}}-CH=CH_2$ | | | " |

## Herstellungsbeispiele

### Beispiel 1 (Verbindung 1)

Umsetzung von Vinylphosphonsäuredichlorid mit 1,1,1-Tris-hydroxymethyl-ethan

240 g (2,0 mol) 1,1,1-Tris-hydroxymethyl-ethan wurden zusammen mit 404 g (4,0 mol) Triethylamin in 1600 ml Tetrahydrofuran gegeben. Unter lebhaftem Rühren wurden 290 g (2,0 mol) Vinylphosphonsäuredichlorid während zwei Stunden unter Kühlung bei 20° C eingetropft. Dann wurde 15 Stunden nachgerührt und anschließend das gebildete Triethylaminhydrochlorid abgesaugt. Es wurde mit Tetrahydrofuran gewaschen und das Filtrat durch Destillation im Vakuum von Tetrahydrofuran befreit. Der Rückstand wurde über einen Dünnschichtverdampfer bei 67 Pa und einer Badtemperatur von 240° C destilliert. Man erhielt 345 g, Fp.: 70 bis 75° C. Durch einen Destillationsversuch wurde der Siedepunkt bestimmt: 213 bis 215° C / 53 Pa. Das Produkt fiel als Diastereomerengemisch an. Die Ausbeute betrug 90 % d. Th.

| $C_7H_{13}O_4P$ (192) | | | |
|---|---|---|---|
| ber.: | 43,75 % C | 6,77 % H | 16,15 % P |
| gef.: | 43,6 % C | 6,8 % H | 16,1 % P |

### Beispiel 2 (Verbindung 2)

Umsetzung von Vinylphosphonsäuredichlorid mit 1,1,1-Tris-hydroxymethyl-propan

280 g (2,09 mol) 1,1,1-Tris-hydroxymethyl-propan und 422 g (4,18 mol) Triethylamin wurden in 1600 ml Tetrahydrofuran gelöst. Dann wurden unter lebhaftem Rühren 303 g (2,09 mol) Vinylphosphonsäuredichlorid während drei Stunden unter Kühlung bei 20° C eingetropft. 15 Stunden wurde nachgerührt und anschließend das gebildete Triethylaminhydrochlorid abgesaugt. Es wurde mit Tetrahydrofuran nachgewaschen und das Filtrat durch Destillation im Vakuum von Tetrahydrofuran befreit. Der Rückstand wurde über einen Dünnschichtverdampfer bei 27 Pa und einer Badtemperatur von 240° C destilliert. Man erhielt 370 g, das Produkt hatte einen Erstarrungspunkt von ca. 25° C. Durch einen Destillationsversuch wurde der Siedepunkt bestimmt: 199° C/13 Pa. $n_D^{20}$ : 1,4890. Das Produkt fiel als Diastereomerengemisch an. Die Ausbeute betrug 86 % d. Th.

| $C_8H_{15}O_4P$ (206) | | | |
|---|---|---|---|
| ber.: | 46,60 % C | 7,28 % H | 15,05 % P |
| gef.: | 46,4 % C | 7,3 % H | 14,8 % P |

### Beispiel 3 (Verbindung 7)

Umsetzung von Methyl-vinylphosphinsäurechlorid mit 1,1,1-Tris-hydroxymethyl-propan im Verhältnis 3:1

20 g (0,15 mol) 1,1,1-Tris-hydroxymethyl-propan und 45,5 g (0,45 mol) Triethylamin wurden in 150 ml Toluol gegeben. Unter lebhaftem Rühren wurden 56 g (0,45 mol) Methyl-vinylphosphinsäurechlorid unter Kühlung bei 20° C eingetropft. Dann wurde 15 Stunden nachgerührt und anschließend das gebildete

Triethylaminhydrochlorid abgesaugt. Es wurde mit Toluol nachgewaschen und das Filtrat durch Destillation unter Vakuum vom Toluol befreit. Es verblieben 58 g des Produktes mit einem Brechungsindex $n_D^{20}$ : 1,4942.
Das Produkt ließ sich über einen Dünnschichtverdampfer bei 27 Pa und einer Badtemperatur von 260 bis 270° C destillieren. Die Ausbeute an dem Rohprodukt betrug 97 % d. Th.

| | | | | |
|---|---|---|---|---|
| $C_{15}H_{29}O_6P_3$ (398) | ber.: | 23,37 % P | gef.: | 23,1 % P |

Beispiel 4 (Verbindung 4)

Umsetzung von Methyl-vinylphosphinsäurechlorid mit Verbindung 2

76 g (0,34 mol) der Verbindung 2 wurden in 100 ml Tetrahydrofuran zusammen mit 34,5 g (0,34 mol) Triethylamin gegeben. Nun wurden 42,5 g (0,34 mol) Methyl-vinylphosphinsäurechlorid unter lebhaftem Rühren und Kühlen bei 20° C eingetropft. Dann wurde 15 Stunden nachgerührt und anschließend das gebildete Triethylaminhydrochlorid abgesaugt. Es wurde mit Tetrahydrofuran gewaschen und das Filtrat durch Destillation im Vakuum von Tetrahydrofuran befreit. Es verblieben 95 g der Verbindung 4. Durch einen Destillationsversuch wurde der Siedepunkt bestimmt: 205 bis 210° C/67 Pa. Die Ausbeute an dem Rohprodukt betrug 95 % d. Th.

| $C_{11}H_{20}O_5P_2$ (294) | | | |
|---|---|---|---|
| ber.: | 21,09 % P | gef.: | 20,5 % P |

Beispiel 5 (Verbindung 5)

Umsetzung von Vinylphosphonsäureethylesterchlorid mit Verbindung 2

34,7 g (0,168 mol) der Verbindung 2 und 17 g (0,168 mol) Triethylamin wurden in 100 ml Toluol gegeben. Dann wurden 26 g (0,168 mol) Vinylphosphonsäureethylesterchlorid unter Rühren und Kühlen bei 20° C eingetropft. Es wurde nachgerührt und abgesaugt. Das Filtrat wurde nach dem Nachspülen mit Toluol von dem Lösungsmittel im Vakuum befreit. Es verblieben 52,5 g der Verbindung 5, $n_D^{20}$ : 1,4848.

Das Produkt konnte im Dünnschichtverdampfer bei 27 Pa und einer Badtemperatur von 240° C destilliert werden. Die Ausbeute an dem Rohprodukt betrug 96 % d. Th.

| $C_{12}H_{22}O_6P_2$ (324) | | | |
|---|---|---|---|
| ber.: | 19,13 % P | gef.: | 18,7 % P |

Beispiel 6 (Verbindung 9)

Umsetzung von Vinylphosphonsäuredichlorid mit Verbindung 2

82,4 g (0,4 mol) der Verbindung 2 und 40,4 g (0,4 mol) Triethylamin wurden in 100 ml Toluol gegeben. Dann wurden 29 g (0,2 mol) Vinylphosphonsäuredichlorid unter Rühren und Kühlen bei 20° C eingetropft. Es wurde nachgerührt, abgesaugt und mit Toluol nachgewaschen. Das Filtrat wurde im Vakuum vom Toluol befreit. Es verblieben 97 g des Produktes mit dem Brechungsindex $n_D^{20}$ : 1,4945.

Das entspricht einer Ausbeute von 100 % d. Th.

| $C_{18}H_{31}O_9P_3$ (484) | | | |
|---|---|---|---|
| ber.: | 19,21 % P | gef.: | 19,2 % P |

Beispiel 7 (Verbindung 3)

Umsetzung von Vinylphosphonsäureanhydrid mit Verbindung 2

321,4 g (1,56 mol) der Verbindung 2 wurden in 321,4 g Methylenchlorid gelöst. Dann wurden 280,8 g (1,56 mol) einer 50 %igen Lösung von Vinylphosphonsäureanhydrid in Methylenchlorid innerhalb einer Stunde unter Rühren eingetropft. Dabei stieg die Temperatur auf 33° C und blieb 30 Minuten bei dieser Temperatur. Dann wurde drei Stunden nachgerührt und anschließend noch 4 Stunden am Rückfluß gekocht. Anschließend wurde das Lösungsmittel im Vakuum innerhalb von ca. drei Stunden bis zu einer Innentemperatur von 50° C abdestilliert. Es verblieben 130 g eines Rohproduktes mit dem Brechungsindex $n_D^{20}$ : 1,4945. Aufgrund eines $^{31}$P-NMR-Spektrums handelte es sich um ein Gemisch zweier Diastereomerer, das in dem Rohprodukt zu etwa 60 % vorlag ($d_6$-DMSO; $\delta$= 14,79; 14,82; 11,78; 12,73 ppm). Das Rohprodukt enthielt 8 % Verbindung 2, 9 % Vinylphosphonsäure und 4 % Vinylpyrophosphonsäure.
$C_{10}H_{18}O_6P_2$ (296)

Beispiel 8 (Verbindung 2)

Veresterung der Vinylphosphonsäure mit 1,1,1-Tris-hydroxymethyl-propan

53,7 g (0,4 mol) 1,1,1-Tris-hydroxymethyl-propan und 43,2 g (0,4 mol) Vinylphosphonsäure wurden unter Rühren bei 67 bis 133 Pa auf 160 bis 170° C erwärmt. Bei nachlassendem Vakuum sammelte sich in einer der Reaktionsapparatur nachgeschalteten Kühlfalle Wasser. Als sich etwa 7,5 g Wasser gesammelt hatten, wurde die Reaktionstemperatur bei wieder verbessertem Vakuum bis auf 200° C gesteigert und eine Stunde bei dieser Temperatur gehalten. Das angefallene Reaktionsgut hatte nun die Säurezahl 134. Anschließend wurde im Dünnschichtverdampfer bei 67 bis 133 Pa und einer Badtemperatur von 270° C destilliert. Das anfallende Produkt hatte die Säurezahl 38 und einen Gehalt von 76 % aufgrund des $^{31}$P-NMR-Spektrums.

Beispiel 9 (Verbindung 7)

Veresterung der Methyl-vinylphosphinsäure mit 1,1,1-Tris-hydroxymethyl-propan

33,6 g (0,25 mol) 1,1,1-Tris-hydroxymethyl-propan und 79,5 g (0,75 mol) Methyl-vinylphosphinsäure wurden bei 67 bis 133 Pa unter lebhaftem Rühren schrittweise während mehrerer Stunden bis auf 190 bis 195° C erhitzt. In einer der Reaktionsapparatur nachgeschalteten Kühlfalle sammelten sich 12 g Wasser. Das anfallende Reaktionsprodukt hatte die Säurezahl 104. Bei 260 bis 270° C und 133 Pa wurde das Produkt in einem Dünnschichtverdampfer destilliert. Man erhielt 81 g mit einem Gehalt von ca. 70 % aufgrund des $^{31}$P-NMR-Spektrums.

Beispiel 10 (Verbindung 7)

Umesterung des Methyl-vinylphosphinsäureethylesters mit 1,1,1-Tris-hydroxymethyl-propan

23,5 g (0,175 mol) 1,1,1-Tris-hydroxymethyl-propan, 70,4 g (0,525 mol) Methyl-vinylphosphinsäureethylester und 2,3 g Orthotitansäure-tetraisopropylester wurden schrittweise im Verlauf mehrerer Stunden unter lebhaftem Rühren bis 210° C erhitzt. Ab etwa 180° C destillierte Ethanol ab. Insgesamt wurden 12 g Ethanol aufgefangen. Das anfallende Rohprodukt hatte die Säurezahl 75. Es konnte bei 53 Pa und einer Badtemperatur von 250 bis 260° C in einem Dünnschichtverdampfer destilliert werden.

Beispiel 11 (Verbindung 10)

Umsetzung von Vinylphosphonsäuredichlorid mit 2,2-Bis-hydroxymethyl-1,3-propandiol

68,1 g (0,5 mol) 2,2-Bis-hydroxymethyl-1,3-propandiol wurden in 400 ml Acetonitril gegeben, dazu wurden 202,4 g (2,0 mol) Triethylamin unter Rühren zugetropft. Dann wurden 145 g (1 mol) Vinylphosphonsäuredichlorid bei 30° C zugetropft und anschließend 15 Stunden nachgerührt. Dann wurde zum Rückfluß erhitzt und nach ca. 15 Minuten heiß abgesaugt; aus dem Filtrat fielen erneut Kristalle aus, die ebenfalls abgesaugt wurden. Insgesamt erhielt man ca. 265 g Triethylaminhydrochlorid. Dann wurde das Acetonitril aus dem Filtrat abdestilliert und der Rückstand mit Aceton digeriert. Man erhielt 125 g Rohprodukt. Dieses wurde aus Isopropanol umkristallisiert.
Fp.: 161° C. Die Ausbeute an Rohprodukt betrug ca. 90 % d. Th.

| $C_9H_{14}O_6P_2$ (280) | | | |
|---|---|---|---|
| ber.: | 38,57 % C | 5,0 % H | 22,14 % P |
| gef.: | 38,3 % C | 4,8 % H | 21,0 % P |

Beispiel 12 (Verbindung 11)

Veresterung der Methyl-vinylphosphinsäure mit 2,2-Bis-hydroxymethyl-1,3-propandiol

13,6 g (0,1 mol) 2,2-Bis-hydroxymethyl-1,3-propandiol (Pentaerythrit) und 42,4 g (0,4 mol) Methyl-vinylphosphinsäure wurden unter lebhaftem Rühren schrittweise während etwa 5 Stunden von 155 bis 190 ° C bei etwa 67 Pa erhitzt. In einer der Reaktionsapparatur nachgeschalteten Kühlfalle sammelten sich etwa 6 g Wasser. Das anfallende Rohprodukt hatte die Säurezahl 115. Der Brechungsindex betrug $n_D^{20}$ : 1,4911.

| $C_{17}H_{32}O_8P_4$ (488) | |
|---|---|
| ber.: | 25,41 % P |
| gef.: | 25,2 % P |

Anwendungsbeispiele

Beispiel 13

145,5 g eines innerlich weichgemachten Vinylalkohol-Copolymeren mit einer Viskosität von 4 mPas in 4 %iger wäßriger Lösung bei 20° C und der Esterzahl 150 wurden durch Rühren in 147 g Wasser bei 90° C gelöst. Nach Abkühlen auf 70° C wurden unter Rühren 100 g der Verbindung 4 (Beispiel 4), 5 g Benzildimethylketal und 1 g 2,6-Di-tert.butyl-4-methylphenol zugegeben. Die homogene Lösung wurde auf eine 0,125 mm dicke Polyethylenterephthalatfolie schichtförmig so aufgetragen, daß nach 48-stündigem Trocknen bei Raumtemperatur eine ca. 1 mm dicke, nicht klebende lichtempfindliche Schicht resultierte. Auf die freie Schichtoberfläche wurde ein mit einem Polyurethan-Haftlack gemäß DE-A 15 97 515

versehenes 0,3 mm dickes Aluminiumblech aufgelegt und das Mehrschichtelement in einer Plattenpresse bei 100° C zwei Minuten gepreßt. Der Haftlack wurde durch Umsetzen eines verzweigten Polyesters aus Adipinsäure, Glycerin und Butylenglykol mit 5,2 % OH-Gruppengehalt mit Triphenylmethan-4,4′,4″-triisocyanat erhalten. Die Dicke der Distanzstücke wurde so gewählt, daß nach dem Heißpressen eine 0,6 mm dicke Photopolymerschicht erhalten wurde. Nach dem Abziehen der Polyesterfolie wurde die lichtempfindliche Schicht bildmäßig 10 Minuten mit einem handelsüblichen UVA-Flachbelichter (Emissionswellenlängenbereich 320 bis 400 nm, Intensität 10 $mW/cm^2$) belichtet. Nach dem Auswaschen der nichtbelichteten Bildstellen mit warmem Wasser wurde eine Hochdruckform mit guter Reliefausbildung und einer Härte von 90 Shore-A erhalten.

Beispiel 14

90 g eines Styrol-Isopren-Styrol-Dreiblock-Copolymeren mit 15 % Styrolgehalt (Cariflex TR 1107 von Shell), 10 g der Verbindung 5, 2 g Benzildimethylketal und 0,5 g 2,6-Di-tert.butyl-4-methylphenol wurden in 100 g Toluol gelöst und auf eine 0,125 mm dicke Polyethylenterephthalatfolie zu einer 6 mm dicken Schicht gegossen. Nach Verdunsten des Toluols wurde auf die freie Oberfläche der 3 mm dicken Photopolymerschicht eine mit einer Haftschicht versehene 0,125 mm dicke Polyethylenterephthalatfolie aufgelegt und das Mehrschichtenelement in einer Plattenpresse bei 100° C 10 Minuten unter Verwendung von 2,8 mm dicken Distanzstücken gepreßt. Nach dem Abstreifen der unbeschichteten Polyesterfolie wurde die Photopolymerschicht mit einem handelsüblichen UVA-Flachbelichter (Emissionswellenlängenbereich 320 bis 400 nm, Intensität 10 $mW/cm^2$) 5 Minuten ohne Vorlage durch die verbliebene Polyesterfolie und 30 Minuten bildmäßig von der freien Schichtseite aus belichtet. Nach dem Auswaschen der nichtbelichteten Bildstellen mit Tetrachlorethen wurde eine elastische Hochdruckform mit guter Reliefausbildung (Relieftiefe 1,3 mm) und einer Härte von 55 Shore-A erhalten.

Beispiel 15

Die Herstellung der Photopolymerschicht und anschließende Verarbeitung zu einer Hochdruckplatte erfolgte analog Beispiel 13, nur wurden diesmal 100 g der Verbindung 7 als vernetzbares Monomeres eingesetzt. Es wurde eine Hochdruckplatte mit guter Reliefausbildung und einer Härte von 98 Shore-A erhalten.

Beispiel 16

Die Herstellung der Photopolymerschicht und anschließende Verarbeitung zu einer Hochdruckplatte erfolgte analog Beispiel 13, nur wurden diesmal 100 g der Verbindung 9 als vernetzbares Monomeres eingesetzt. Es wurde eine Hochdruckplatte mit guter Reliefausbildung und einer Härte von 95 Shore-A erhalten.

Beispiel 17

Die Herstellung der Photopolymerschicht und anschließende Verarbeitung zu einer Hochdruckplatte erfolgte analog Beispiel 13, nur wurden diesmal 145,5 g des Vinylalkohol-Copolymeren, 44,6 g der Verbindung 10, 3,9 g Benzildimethylketal und 0,8 g 2,6-Di-tert.butyl-4-methyl-phenol zu einer Photopolymerschicht verarbeitet. Es wurde eine Hochdruckplatte mit guter Reliefausbildung und einer Härte von 98 Shore-A erhalten.

**Ansprüche**

1. Durch Strahlung polymerisierbares Gemisch, das als wesentliche Bestandteile
a) ein polymeres Bindemittel,
b) eine radikalisch polymerisierbare Verbindung und

c) eine Verbindung oder eine Verbindungskombination enthält, die unter Einwirkung aktinischer Strahlung die Polymerisation der Verbindung (b) zu initiieren vermag,
dadurch gekennzeichnet, daß die polymerisierbare Verbindung eine Verbindung der Formel I ist

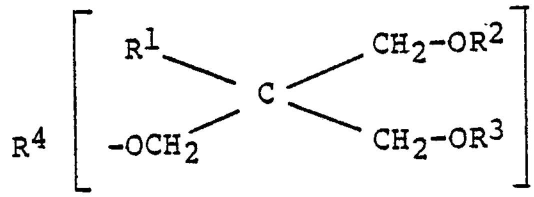

(I)

worin
$R^1$ eine Alkylgruppe mit 1 bis 4 Kohlenstoffatomen, $CH_2OH$ oder $CH_2OR^7$,
$R^2$ eine Gruppe der Formel II

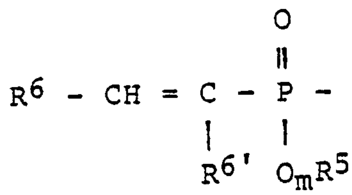

(II) und

$R^3$ ein Wasserstoffatom oder eine Gruppe der Formel II ist
oder worin
$R^2$ und $R^3$ zusammen eine Gruppe der Formel III

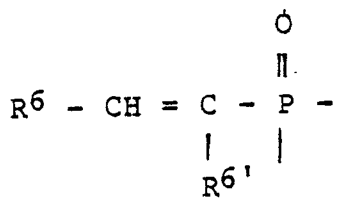

(III)

bedeuten,
n 1 oder 2,
$R^4$ bei n = 1 ein Wasserstoffatom, eine Gruppe der Formel II oder, wenn $R^2$ und $R^3$ eine Gruppe der Formel III bilden und $R^1$ eine Alkylgruppe ist, auch eine Gruppe der Formel IV

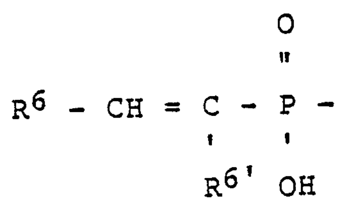

(IV)

und bei n = 2 eine Gruppe der Formel III bedeutet,
$R^5$ eine Alkylgruppe mit 1 bis 4 Kohlenstoffatomen,
$R^6$ und $R^{6'}$ gleich oder verschieden sind und Wasserstoffatome oder Alkylgruppen mit 1 bis 4 Kohlenstoffatomen sind und
$R^7$ eine Gruppe der Formel II ist,
oder worin, bei n = 1, $R^4$ und $R^7$ zusammen eine Gruppe der Formel III bedeuten und
m O oder 1 ist.

2. Durch Strahlung polymerisierbares Gemisch nach Anspruch 1, dadurch gekennzeichnet, daß $R^1$ eine Alkylgruppe mit 1 oder 2 Kohlenstoffatomen ist.

3. Durch Strahlung polymerisierbares Gemisch nach Anspruch 1, dadurch gekennzeichnet, daß $R^6$ ein Wasserstoffatom oder eine Methylgruppe ist.

4. Durch Strahlung polymerisierbares Gemisch nach Anspruch 1, dadurch gekennzeichnet, daß das Bindemittel (a) in Wasser oder wäßrig-alkalischen Lösungen löslich ist.

5. Durch Strahlung polymerisierbares Gemisch nach Anspruch 1, dadurch gekennzeichnet, daß der Polymerisationsinitiator (c) gegen sichtbares oder langwelliges ultraviolettes Licht empfindlich ist.

6. Durch Strahlung polymerisierbares Gemisch nach Anspruch 1, dadurch gekennzeichnet, daß es 20 bis 95 Gew.-% polymeres Bindemittel (a), 5 bis 80 Gew.-% polymerisierbare Verbindung (b) und 0,01 bis 10 Gew.-% Polymerisationsinitiator (c) enthält.

7. Durch Strahlung polymerisierbares Aufzeichnungsmaterial aus einer strahlungsempfindlichen Schicht und ggf. einem Schichtträger, dadurch gekennzeichnet, daß die strahlungsempfindliche Schicht aus einem Gemisch gemäß Anspruch 1 besteht.